# EUROPEAN PATENT APPLICATION

(11) **EP 4 704 347 A1**
(43) Date of publication of application: **04.03.2026**
(21) Application number: 24196469.1
(22) Date of filing: 26.08.2024
(51) Int. Cl.: H03M 1/72, H04B 14/02

(54) **A UNIT CELL-BASED DAC**

(71) Applicant: NXP B.V., 5656 AG Eindhoven (NL)
(72) Inventor: KUMAR, Niraj, 5656 AG Eindhoven (NL); BESTEN, Gerrit Willem den, 5656 AG Eindhoven (NL)
(74) Representative: Schmütz, Christian Klaus Johannes

(57) **Abstract**

There is disclosed a unit cell-based DAC configured to operate in N consecutive phases, wherein the unit cell-based DAC comprises a plurality of unit cells and wherein a single transition between a first state and a second state of the unit cell-based DAC is caused by M transitions of the plurality of unit cells between corresponding first states and second states, where M is smaller than N, wherein each transition of a unit cell is configured to occur during one of the N phases and wherein the interconnections of the unit cells are reconfigurable such that the unit cell-based DAC is configured to switchably operate in one of a PAM3 mode, in which the unit cell-based DAC converts a two-bit input signal into a three-level output signal, and a PAM4 mode in which the unit cell-based DAC converts the two-bit input signal into a four-level output signal.

## Description

### Field

The present disclosure relates to a unit cell-based DAC configured to operate in N consecutive phases. In particular the disclosure relates to a multi-standard unit cell-based DAC.

### Summary

According to a first aspect of the present disclosure, there is provided a unit cell-based DAC configured to operate in N consecutive phases, wherein the unit cell-based DAC comprises a plurality of unit cells and wherein a single transition between a first state and a second state of the unit cell-based DAC is caused by M transitions of the plurality of unit cells between corresponding first states and second states, where M is smaller than N, wherein each transition of a unit cell is configured to occur during one of the N phases and wherein the interconnections of the unit cells are reconfigurable such that the unit cell-based DAC is configured to switchably operate in one of a PAM3 mode, in which the unit cell-based DAC converts a two-bit input signal into a three-level output signal, and a PAM4 mode in which the unit cell-based DAC converts the two-bit input signal into a four-level output signal.

In one or more embodiments, the number of unit cells in the unit cell-based DAC may be based on a multiple of M and N.

In one or more embodiments, M may be greater than half the value of N.

In one or more embodiments, the transitions of the unit cells may be monotonic transitions.

In one or more embodiments, switching between the PAM3 mode and the PAM4 mode may comprise adjusting how the input signal is distributed to the unit cells.

In one or more embodiments, the number of unit cells utilised in the PAM3 mode may be equal to the number of unit cells used in the PAM4 mode.

In one or more embodiments, when operating in the PAM3 mode, the same number of unit cells may be activated during each phase during which transitions take place.

In one or more embodiments, when operating in the PAM4 mode, the same number of unit cells may be activated during each phase during which transitions take place.

In one or more embodiments, the number of unit cells activated during each respective phase when operating in the PAM3 mode may be the same as the number of unit cells activated during each corresponding respective phase when operating in the PAM4 mode.

In one or more embodiments, a differential impedance during each phase of the PAM3 and PAM4 mode may be configured to be constant and matched.

In one or more embodiments, the number of unit cells activated during each respective phase when operating in the PAM4 mode may be configured drive a zero differential symbol.

In one or more embodiments, the number of phases may be proportional to an oversample ratio and wherein the oversample ratio is based on a line driver DAC frequency.

In one or more embodiments, the duration of each phase may be based on a duration of a line driver DAC frequency received by the unit cell-based DAC and the oversampling ratio.

According to a second aspect of the present disclosure, there is provided a vehicle comprising the unit cell-based DAC of the first aspect.

While the disclosure is amenable to various modifications and alternative forms, specifics thereof have been shown by way of example in the drawings and will be described in detail. It should be understood, however, that other embodiments, beyond the particular embodiments described, are possible as well. All modifications, equivalents, and alternative embodiments falling within the spirit and scope of the appended claims are covered as well.

The above discussion is not intended to represent every example embodiment or every implementation within the scope of the current or future Claim sets. The figures and Detailed Description that follow also exemplify various example embodiments. Various example embodiments may be more completely understood in consideration of the following Detailed Description in connection with the accompanying Drawings.

### Brief Description of the Drawings

One or more embodiments will now be described by way of example only with reference to the accompanying drawings in which:
Figure 1 shows an example embodiment of a unit cell-based DAC operating in a PAM3 mode;
Figure 2 shows another example embodiment of a unit cell-based DAC operating in a PAM4 mode;
Figure 3 shows an example transient response showing monotonicity with the pulse shapes generated by the unit cell-based DAC operating in a PAM3 mode;
Figure 4 shows an example transient response showing monotonicity with the pulse shapes generated by the unit cell-based DAC operating in a PAM4 mode;
Figure 5 shows an example PSD plot of a PAM-3 block wave vs a trapezoidal wave shape;
Figure 6 shows an example PSD plot of a PAM-4 block wave vs a trapezoidal wave shape;
Figure 7 shows an example embodiment of a unit cell-based DAC operating in a PAM4 mode with addition of Send_Z level; and
Figure 8 shows an example vehicle comprising a unit cell-based DAC of the present disclosure.

### Detailed Description

The present disclosure relates to a unit cell-based DAC which is configured to switchably operate in one of a PAM3 mode and a PAM4 mode. In the PAM3 mode, the unit cell-based DAC is configured to convert a two-bit input signal into a three-level output signal. In the PAM 4 mode, the unit cell-based DAC is configured to convert the two-bit input signal into a four-level output signal.

In one or more embodiments, the unit cell-based DAC of the present disclosure may be implemented in automotive settings, such as in a vehicle. It will be appreciated, however, that the unit cell-based DAC of the present disclosure may be implemented in fields broader than the automotive field.

For example, automotive 1Gb/s operation over single twisted-pair Copper cable (IEEE Std 802.3bp^{™}-2016) standard uses PAM3 modulation and defines a PSD mask. Meeting this PSD mask may require partial response filtering. This interface uses common mode choke to meet EMC performance where differential to common mode conversion of common mode choke is significant cause for higher emission. Hence, sophisticated pulse shaping is required for better EMC performance.

On the other hand, automotive Multigig 2.5 Gb/s, 5 Gb/s and 10Gb/s standard (IEEE Std 802.3ch^{™}-2020) uses PAM4 modulation and defines different PSD mask which has more natural roll off. This requires different pulse shape and a partial response filter is not required. Pulse shaping in this mode is primarily done to reduce out of band energy for better EMC performance.

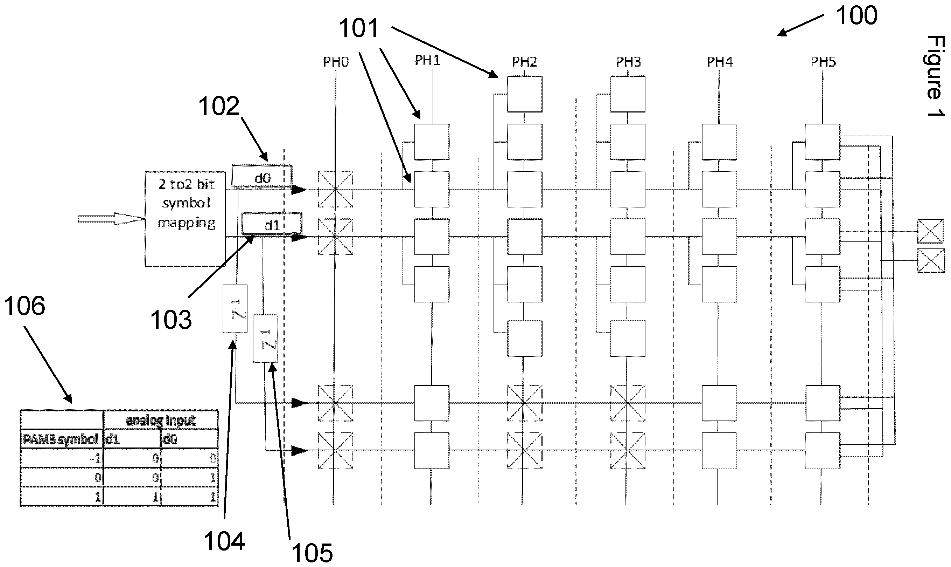

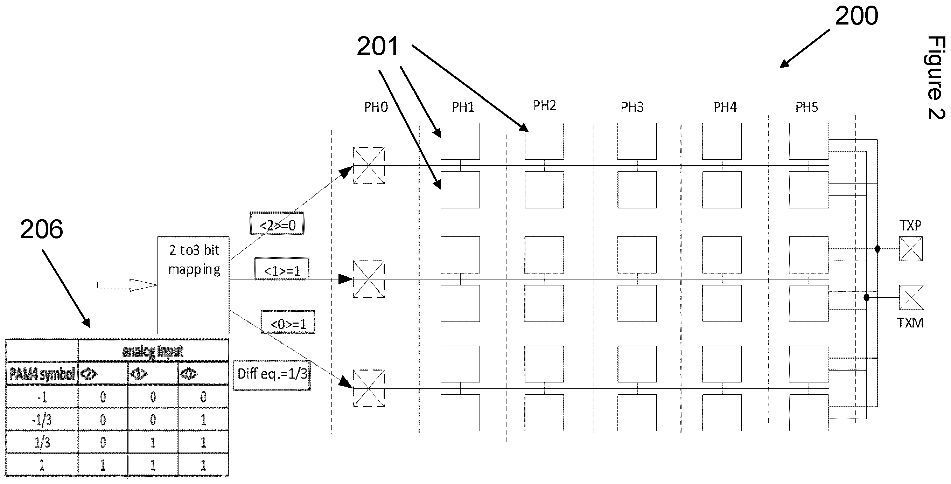

Figure 1 shows the configuration of a unit cell-based DAC (UCB DAC) 100 according to the present disclosure when operating in the PAM3 mode. Figure 2 shows the configuration of a unit cell-based DAC 200 according to the present disclosure when operating in the PAM4 mode. A UCB DAC 100, 200 is a DAC which comprises a plurality of individual unit cells which are configured to generate an analog output signal. Each unit cell may contribute a small fixed amount of current or voltage or impedance to the overall signal. Properties of a digital input signal received by the UCB DAC 100, 200 may determine which unit cells are active and contribute to the output signal and how signals are distributed to those unit cells. In general terms, a UCB DAC 100, 200 can be used in implementing one of PAM3 or PAM4 by designing a DAC architecture which supports one of these modes of operation to map three-level symbols or four-level symbols, respectively.

The UCB DAC 100, 200 is configured to operate in a plurality of consecutive phases. The number of phases in which the UCB DAC operates may be labelled as N phases and the value of N may be proportional to an oversample ratio. The oversample ratio may be based on a line driver DAC frequency received by the UCB DAC 100, 200. The oversample ratio may also be selected based on a maximum frequency allowed by an EMC mask which is to be conformed to. Further, the duration of each phase may be based on a duration of the line driver DAC frequency received by the UCB DAC 100, 200 and the oversampling ratio.

Each phase of the UCB DAC 100, 200 is a period of time during which unit cells 101, 201 of the UCB DAC 100, 200 can undergo transitions between a first state and a second state. That is, the unit cells 101, 201 may transition from a first state to a second state or from the second state to the first state. A single transition of the UCB DAC 100, 200 only occurs when a predetermined number of unit cell 101, 201 transitions have occurred. The number of transitions required to cause a transition in the overall UCB DAC 100, 200 may be labelled as M transitions. M is smaller than N, which is to say that the number of transitions required to cause a change from a +1 state to a 0 state, for example, requires fewer unit cell transitions than the number of phases available. By providing for M transitions where M is smaller than the number of phases, N, one may generate trapezoidal waveforms instead of triangular waveforms because during one of the phases, no transition takes place. A trapezoidal waveform may be able to meet PSD mask requirements both in PAM3 and PAM4 modes of operation where a triangular waveform has been found to not meet these requirements.

In one or more embodiments, M may be greater than half the value of N. In some embodiments, M may be one fewer than N. The exact difference between M and N may be based on the value of N and on the PSD mask requirements for operation in each of PAM3 and PAM4.

The interconnections of the unit cells 101, 201 may be reconfigurable such that the UCB DAC 100, 200 is configured to switchably operate in one of the PAM3 mode or the PAM4 mode. The UCB DAC 100, 200 may be configured to operate in the PAM3 mode when operating at 1Gb/s while the UCB DAC may be configured to operate in the PAM4 mode when operating at the 2.5Gb/s. The UCB DAC 100, 200 may be configured to detect the speed of an incoming digital data signal and adjust its mode of operation in order to operate in the appropriate mode based on the detected speed of the incoming data signal. In other embodiments, the UCB DAC 100, 200 may be configured to be manually switched between the PAM3 and PAM4 modes. Whether operating in either the PAM3 mode or PAM4 mode, the UCB DAC 100, 200 may be configured to provide the incoming data signal to unit cells 101, 201 based on the current phase and the mode of operation such that the interconnections of the unit cells 101, 201 are effectively switched. It will be appreciated that the interconnections may not be physically altered but that, instead, the incoming signal may be routed and/or filtered in such a way as to allow provide for an effective reconfiguration of the interconnections of the unit cells 101, 201.

In one or more embodiments, the number of unit cells 101, 201 in the UCB DAC must be a multiple of 2 for the PAM3 mode while the number of unit cells 101, 201 must be a multiple of 3 for the PAM4 mode. Thus, in order to have a configurable unit cell scheme with 5 steps, for example, a minimum of 30 cells would be required which can be derived as the lowest common multiple of 2, 3 and 5. It will be appreciated that other higher common multiples may also be used. In particular, the number of unit cells 101, 201 activated in the PAM3 mode may be the same as the number of unit cells activated in the PAM4 mode. That is, the number of unit cells 101, 201 which undergo transitions in order to cause a transition of the UCB DAC 100, 200 may be the same in both the PAM3 mode and the PAM4 mode. Every unit cell is assigned a clock phase and this does not change. Because we have a fixed number of unit cells in each mode, the clock loading of the unit cells remains constant and because it remains constant, this allows it to remain low and thereby not impact the performance of the unit cells. Further, in each phase of the PAM3 and PAM4 modes, the differential impedance is both constant (that is, unchanging) and matched to the cable.

When operating in the PAM3 mode, the number of unit cells 101, 201 activated in each phase in which unit cells 101, 201 are activated may be the same as in each other phase in which unit cells 101, 201 are activated. That is, while there are one or more phases in which unit cells are not activated, in each other phase during which unit cells 101, 201 are activated, the number of unit cells 101, 201 which are activated is the same.

Similarly, when operating in the PAM4 mode, the number of unit cells 101, 201 activated in each phase in which unit cells 101, 201 are activated may be the same as in each other phase in which unit cells 101, 201 are activated. That is, while there are one or more phases in which unit cells 101, 201 are not activated, in each other phase during which unit cells 101, 201 are activated, the number of unit cells 101, 201 which are activated is the same.

Yet further, the number of unit cells 101, 201 activated in each phase when operating in the PAM3 mode may be the same as the number of unit cells 101, ,201 activated during the corresponding phase when operating in the PAM4 mode.

In one or more embodiments, the transitions of the unit cells 101, 201 of the UCB DAC 100, 200 may be monotonic transitions when operating in each of the PAM3 and PAM4 modes.

The example embodiment depicted in Figure 1 represents a PAM3 implementation which is suitable for 1 Gb/s operation. In this implementation, 30 unit cells 101, 102 are provided which are configured to activate across five of an available six phases. While figure 1 shows that the first phase is a phase in which no unit cells are activated, the unused phase may instead be any other phase in other embodiments. It has been found that an embodiment such as that shown in figure 1 may improve an excessive PSD roll-off by approximately 400 MHz with respect to a similar UCB DAC which implements a triangular waveform by activating unit cells across all six phases. It has further been found that the baseband PSD is the same as a similar UCB DAC which implements a triangular waveform until 100 MHz, which is desirable.

As shown in the arrangement of figure 1, incoming data is separated into d0 and d1 signals along first and second main tap lines 102, 103 with two corresponding Z⁻¹ partial tap lines 104, 105. Each of phases 1-5 (the first through fifth phases) comprise six unit cells such that each phase has an equal load. Data indicative of a preceding bit (an n-1th bit), such as the immediately preceding bits, may be received at the partial tap lines 104, 105 and provided to the unit cells of the partial tap lines. The unit cell-based DAC may be configured to apply a weighting to the partial tap lines. The weighting may be such that the output signal of the unit cell-based DAC is primarily determined by the signals on the first and second main tap lines. (102, 103). For example, a normalised weighting of 0.8 may be applied to the first and second main tap lines while a normalised weighting of 0.2 may be applied to the partial tap lines. While 0.8 and 0.2 are used as examples herein, it will be appreciated that any weighting, including an equal weighting, may be used.

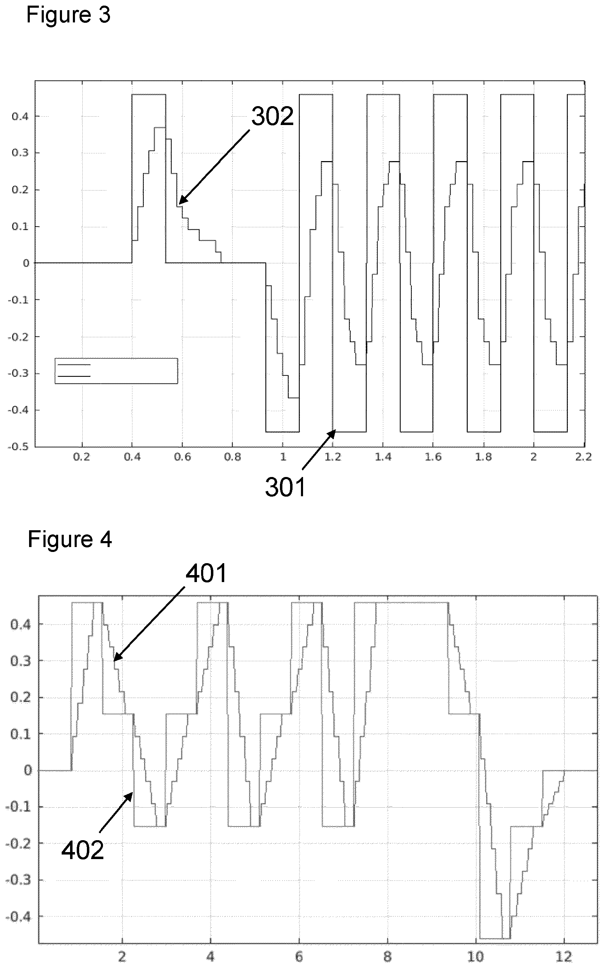

As can be seen in figure 2, this distribution of unit cells 201, 202 between the phases is kept the same in the PAM4 implementation. By keeping the number of unit cells 101, 201 in each phase equal in both PAM3 and PAM4 modes, a need for a clock multiplexer is avoided, thereby simplifying the unit cell-based DAC. The 24 unit cells 101 used in the main tap lines 102, 103 are weighted with a ratio of [0, 4, 6, 6, 4, 4] from phases 0 - 5 (the zeroth through fifth phases), respectively. Similarly, the 6 unit cells 101 used in the partial tap lines 104, 105 are weighted with a ratio of [0, 2, 0, 0, 2, 2] from phases 0 - 5 (the zeroth through fifth phases), respectively. This can be seen in figure 1. Overall, the main tap lines have a weight of 0.8 and the partial response tap lines 104, 105 have a weight of 0.2. As the weights are not the same in the main tap lines 102, 103 across all phases, the shape of the output signal resembles a partial parabolic signal. This may result in the total level shift of the UCB DAC being different from one overall UCB DAC transition to another when operating in the PAM3 mode. This partial response behaviour can be seen in figure 3 where, for example, the level of the proposed lineshape 301 at approximately time = 1×10⁻⁸ second is less than the level of the lineshape 301 shown at approximately time = 1.3×10⁻⁸ seconds. Regardless of the difference in level, both lineshape levels result in an equal overall change in the state of the UCB DAC. As shown in the table 106 of figure 1, a PAM3 -1 signal may be represented as a 0 signal in both d1 and d0. A PAM3 0 signal may be represented as a 0 signal in d1 and a 1 signal in d0. A PAM3 -1 signal may be presented as a -1 signal in both d1 and d0.

As shown in figure 2, incoming data is separated into three different signals: an <2> = 0, <1> = 1 and <0> = 1 signal. In this mode, as for the PAM3 mode depicted in figure 1, 30 unit cells are used. The trapezoidal interpolation is sufficient to meet PSD requirements, herein the trapezoidal interpolation is achieved by using a linear sum of 5 out of 6 available phases. Once more, each phase has 6 unit-cells and hence an equal load in each of the 5 phases in which unit cells 201 undergo transitions. This is the same as in the PAM3 mode, thereby removing any need for a clock multiplexer. As shown in the table 206 of figure 2, a PAM4 -1 signal results from a 0 in each of the <2>, <1> and <0> signals. A PAM4 -1/3 signal results from a 0 in each of the <2> and <1> signals and a 1 in the <0> signal. A PAM4 1/3 signal results from a 0 in the <2> signal and a 1 in each of the <1> and <0> signals. A PAM4 1 signal results from a 1 in each of the <2>, <1> and <0> signals lines.

Figure 3 shows an example PAM3 trapezoidal with partial parabolic response as implemented by embodiments such as that shown in, and described with respect to, figure 1. Seconds with a multiplication factor of ×10⁻⁸ are provided along the x-axis while Volts are provided along the y-axis. The overall UCB DAC transitions 301 are shown alongside the unit cell transitions 302 which, together, cause the overall UCB DAC transitions/level shifts. After 5 unit cell transitions 302, an overall UCB DAC transition is induced 301.

Figure 4 shows an example PAM4 trapezoidal response as implemented by embodiments such as that shown in, and described with respect to, figure 2. Seconds with a multiplication factor of ×10⁻⁹ are provided along the x-axis while Volts are provided along the y-axis. As can be seen, after 5 unit-cell transitions 401, which results in a trapezoidal waveform, a transition 402 in the unit cell-based DAC is triggered.

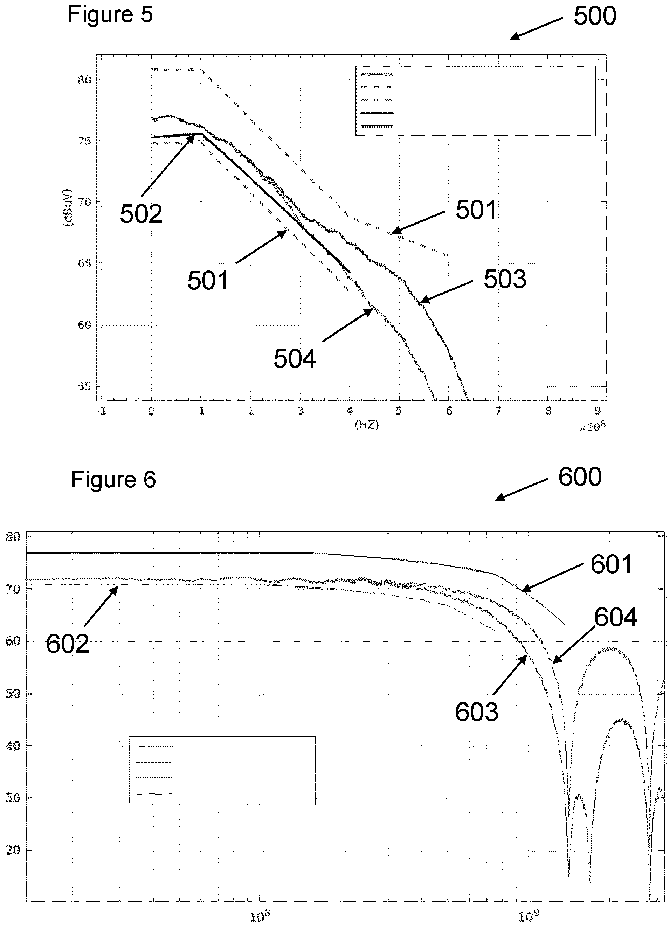

Figure 5 shows an example PSD plot 500 of a PAM3 block wave and trapezoidal with partial parabolic waveshape. The upper and lower PSD masks 501 (marked with a dotted line) define the values within which it is desirable to maintain the output signal. Line 502 shows a modified lower PSD mask once several standard types of losses are taken into account. The signal produced by the trapezoidal with partial parabolic lineshape remains firmly within the bounds of the PSD mask, including the modified lower PSD mask 502. On the other hand, the signal produced by a triangular lineshape strays 504 close to the lower PSD mask 502 and crosses the modified lower PSD mask, which may be considered unacceptable. The X-axis is frequency in Hz and the Y-axis is PSD spectrum in dBuV. Thus, figure 5 demonstrates the effect of the UCB DAC of the present disclosure.

Figure 6 shows an example PSD plot 600 of a PAM4 block wave and the trapezoidal wave shape. The upper PSD mask 601 and lower PSD mask 602 define the values which it is desirable to maintain the trapezoidal waveshape within 603. The block PSD wave shape 604 is also represented. As can be seen, the trapezoidal wave shape maintains a position within the upper and lower PSD mask bounds 601, 602. The PSD wave shape 603 comfortably remains within the PSD mask and would continue to do so after additional losses are considered. Conversely, the PSD waveshape 604 would produce excessive out of band energy which is bad for emission. Out of band energy is significantly reduced in 603 for frequency > 1Ghz. The X-axis is frequency in Hz and the Y-axis is PSD spectrum in dBuV. This demonstrates the benefit of the disclosed approach.

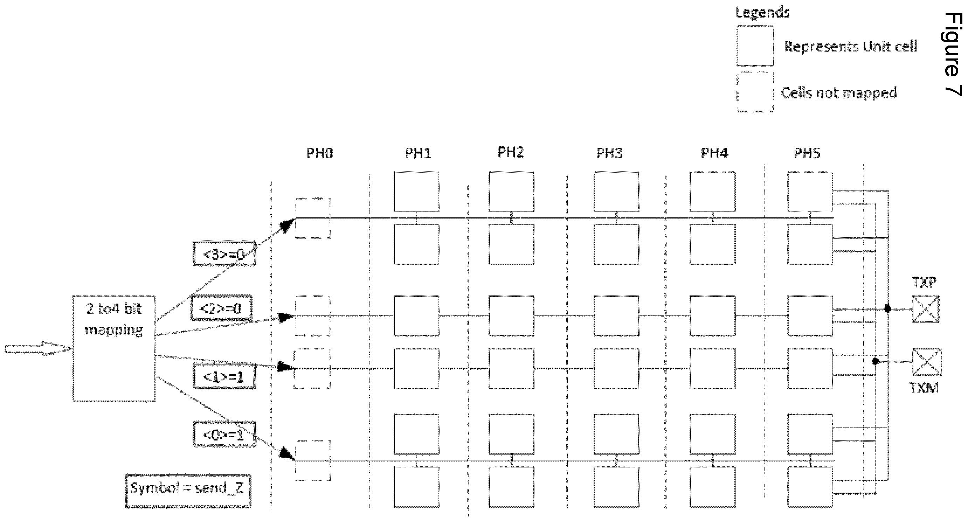

Figure 7 shows an example of zero differential symbol (send_Z) implementation in a PAM4 mode which may be used to drive zero differential signal on lines. As the total number of cells are even, half of cells are configured to drive "high" and remaining half of cells are configured to drive "low" to achieve zero differential symbol. The example PAM4 implementation described with reference to figure 2 with 2-bit to 3-bit mapping can also be configured to operate in a zero differential symbol (send Z) implementation as described with reference to figure 7 for an additional level of send_Z with 2-bit to 4-bit mapping. This may be achieved by using a data multiplexer to shift from one mode to another, however, no clock multiplexer required.

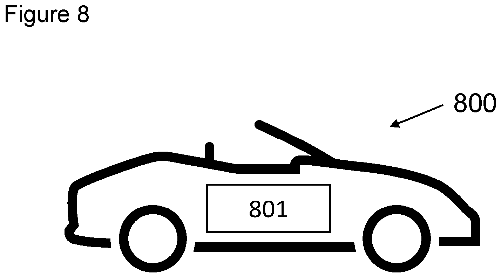

Figure 8 shows an example vehicle 800 comprising the unit cell-based DAC 801 of the present disclosure.

It will be appreciated that alternative embodiments exist beyond those described with reference to figures 1 and 2. For example, in both a PAM3 and PAM4 mode of an alternative unit cell-based DAC, 60 unit cells may be used. A trapezoidal curve with linear interpolation may be used wherein, once more, transitions occur during 5 out of 6 available phases. In this embodiment, 12 unit cells may be activated per phase with 5 unit cells on each of the d0 or d1 main tap lines and one unit cell on each corresponding partial tap Z⁻¹ lines. In such embodiments, the partial response tap filter may have a ratio of 0.8333:0.1666. In the corresponding PAM4 mode, there may be similarly provided 60 unit cells with unit cell transitions occurring during 5 of the 6 available phases and wherein 12 unit cells undergo transitions during each phase in which transitions take place.

The instructions and/or flowchart steps in the above figures can be executed in any order, unless a specific order is explicitly stated. Also, those skilled in the art will recognize that while one example set of instructions/method has been discussed, the material in this specification can be combined in a variety of ways to yield other examples as well, and are to be understood within a context provided by this detailed description.

In some example embodiments the set of instructions/method steps described above are implemented as functional and software instructions embodied as a set of executable instructions which are effected on a computer or machine which is programmed with and controlled by said executable instructions. Such instructions are loaded for execution on a processor (such as one or more CPUs). The term processor includes microprocessors, microcontrollers, processor modules or subsystems (including one or more microprocessors or microcontrollers), or other control or computing devices. A processor can refer to a single component or to plural components.

In other examples, the set of instructions/methods illustrated herein and data and instructions associated therewith are stored in respective storage devices, which are implemented as one or more non-transient machine or computer-readable or computer-usable storage media or mediums. Such computer-readable or computer usable storage medium or media is (are) considered to be part of an article (or article of manufacture). An article or article of manufacture can refer to any manufactured single component or multiple components. The non-transient machine or computer usable media or mediums as defined herein excludes signals, but such media or mediums may be capable of receiving and processing information from signals and/or other transient mediums.

Example embodiments of the material discussed in this specification can be implemented in whole or in part through network, computer, or data based devices and/or services. These may include cloud, internet, intranet, mobile, desktop, processor, look-up table, microcontroller, consumer equipment, infrastructure, or other enabling devices and services. As may be used herein and in the claims, the following non-exclusive definitions are provided.

In one example, one or more instructions or steps discussed herein are automated. The terms automated or automatically (and like variations thereof) mean controlled operation of an apparatus, system, and/or process using computers and/or mechanical/electrical devices without the necessity of human intervention, observation, effort and/or decision.

It will be appreciated that any components said to be coupled may be coupled or connected either directly or indirectly. In the case of indirect coupling, additional components may be located between the two components that are said to be coupled.

In this specification, example embodiments have been presented in terms of a selected set of details. However, a person of ordinary skill in the art would understand that many other example embodiments may be practiced which include a different selected set of these details. It is intended that the following claims cover all possible example embodiments.

## Claims

1. A unit cell-based DAC configured to operate in N consecutive phases, wherein the unit cell-based DAC comprises a plurality of unit cells and wherein a single transition between a first state and a second state of the unit cell-based DAC is caused by M transitions of the plurality of unit cells between corresponding first states and second states, where M is smaller than N, wherein each transition of a unit cell is configured to occur during one of the N phases and wherein the interconnections of the unit cells are reconfigurable such that the unit cell-based DAC is configured to switchably operate in one of a PAM3 mode, in which the unit cell-based DAC converts a two-bit input signal into a three-level output signal, and a PAM4 mode in which the unit cell-based DAC converts the two-bit input signal into a four-level output signal.

2. The unit cell-based DAC of claim 1 wherein the number of unit cells in the unit cell-based DAC is based on a multiple of M and N.

3. The unit cell-based DAC of any preceding claim wherein M is greater than half the value of N.

4. The unit cell-based DAC of any preceding claim wherein the transitions of the unit cells are monotonic transitions.

5. The unit cell-based DAC of any preceding claim wherein switching between the PAM3 mode and the PAM4 mode comprises adjusting how the input signal is distributed to the unit cells.

6. The unit cell-based DAC of any preceding claim wherein the number of unit cells utilised in the PAM3 mode is equal to the number of unit cells used in the PAM4 mode.

7. The unit cell-based DAC of any preceding claim wherein, when operating in the PAM3 mode, the same number of unit cells are activated during each phase during which transitions take place.

8. The unit cell-based DAC of any preceding claim wherein, when operating in the PAM4 mode, the same number of unit cells are activated during each phase during which transitions take place.

9. The unit cell-based DAC of any preceding claim wherein the number of unit cells activated during each respective phase when operating in the PAM3 mode is the same as the number of unit cells activated during each corresponding respective phase when operating in the PAM4 mode.

10. The unit cell-based DAC of any preceding claim wherein a differential impedance during each phase of the PAM3 and PAM4 mode is configured to be constant and matched.

11. The unit cell-based DAC of any preceding claim wherein the number of unit cells activated during each respective phase when operating in the PAM4 mode are configured drive a zero differential symbol.

12. The unit cell-based DAC of any preceding claim wherein the number of phases is proportional to an oversample ratio and wherein the oversample ratio is based on a line driver DAC frequency.

13. The unit cell-based DAC of claim 12 wherein the duration of each phase is based on a duration of a line driver DAC frequency received by the unit cell-based DAC and the oversampling ratio.

14. A vehicle comprising the unit cell-based DAC of any preceding claim.
